(19) Europäisches Patentamt / European Patent Office / Office européen des brevets

(11) **EP 4 123 321 B1**

(12) # EUROPÄISCHE PATENTSCHRIFT

(45) Veröffentlichungstag und Bekanntmachung des Hinweises auf die Patenterteilung:
**30.10.2024 Patentblatt 2024/44**

(21) Anmeldenummer: **21187495.3**

(22) Anmeldetag: **23.07.2021**

(51) Internationale Patentklassifikation (IPC):
**G01R 31/367** (2019.01)   **G01R 31/382** (2019.01)
**G01R 31/392** (2019.01)

(52) Gemeinsame Patentklassifikation (CPC):
**G01R 31/367; G01R 31/382; G01R 31/392;**
Y02E 60/10; Y02W 30/84

(54) **VERFAHREN, VORRICHTUNG UND COMPUTERPROGRAMMPRODUKT ZUR RESTWERTBESTIMMUNG VON BATTERIESPEICHERN**

METHOD, DEVICE AND A COMPUTER PROGRAM FOR IDENTIFYING THE RESIDUAL VALUE OF BATTERY STORAGE DEVICES

PROCÉDÉ, DISPOSITIF ET PRODUIT-PROGRAMME INFORMATIQUE DESTINÉS À LA DÉTERMINATION D'UNE VALEUR RÉSIDUELLE DES ACCUMULATEURS DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**25.01.2023 Patentblatt 2023/04**

(73) Patentinhaber: **Siemens Aktiengesellschaft**
**80333 München (DE)**

(72) Erfinder:
- **Arzberger, Arno**
  **96135 Stegaurach (DE)**
- **Baldauf, Manfred**
  **91056 Erlangen (DE)**
- **Schulte, Sascha**
  **91315 Höchstadt (DE)**

(74) Vertreter: **Siemens Patent Attorneys**
**Postfach 22 16 34**
**80506 München (DE)**

(56) Entgegenhaltungen:
**WO-A1-2021/089786     JP-B1- 6 494 840**

- ZHANG SHUZHI ET AL: "A rapid online calculation method for state of health of lithium-ion battery based on coulomb counting method and differential voltage analysis", JOURNAL OF POWER SOURCES, ELSEVIER, AMSTERDAM, NL, vol. 479, 31 August 2020 (2020-08-31), XP086345101, ISSN: 0378-7753, [retrieved on 20200831], DOI: 10.1016/J.JPOWSOUR.2020.228740
- ZHENG YUEJIU ET AL: "Study on the correlation between state of charge and coulombic efficiency for commercial lithium ion batteries", JOURNAL OF POWER SOURCES, ELSEVIER, AMSTERDAM, NL, vol. 289, 18 May 2015 (2015-05-18), pages 81 - 90, XP029242205, ISSN: 0378-7753, DOI: 10.1016/J.JPOWSOUR.2015.04.167

**Beschreibung**

Lithium-Ionen-Akkumulatoren werden aufgrund ihrer hohen Leistungs- und Energiedichte in vielen mobilen und stationären Anwendungen als Energiespeicher eingesetzt. Neu ist dabei der stark zunehmende Einsatz in elektrisch angetriebenen Fahrzeugen und als stationäre Zwischenspeicher für die elektrische Versorgung in Gebäuden. Im Folgenden werden die Akkumulatoren wie in diesen technischen Einsatzgebieten in der Alltagssprache als Batterie oder Batteriespeicher bezeichnet.

Ab etwa 2025 werden die ersten Traktionsbatterien in größeren Stückzahlen von mehr als 10000 für den Einsatz im Fahrzeug ausgedient haben, weil ihre Restkapazität nach ca. 5 bis 8 Jahren Betrieb im Fahrzeug zu gering geworden ist oder das Fahrzeug aus anderen Gründen verschrottet wird. Im Idealfall könnten diese Batterien noch viele Jahre als stationäre Speicher für netzdienliche Zwecke verwendet werden. Auch solche Batterien, die nicht aufgrund ihres eigenen Alters, sondern aus anderen Gründen nicht mehr in einem Fahrzeug eingesetzt werden sollten, kommen hierfür in Frage.

Diese als "Second-Life" bezeichnete Anwendung steht jedoch in Konkurrenz zum Rohstoffrecycling, wodurch sich eine Mindest-Qualität und Restlebensdauer und damit ein Minimum für den Restwert der ausgedienten Batterien definiert, unterhalb dem ein Einsatz im Second-Life nicht lohnenswert ist.

Die Batteriemanagementsysteme von gebrauchten Batterien liefern dazu typischerweise eine Aussage. Diese ist aber so ungenau, dass Geschäftsmodelle für stationäre Speicher aus Second-Life-Batterien oder gebrauchten Batterien als Ersatzteil nicht tragfähig sind.

Zur Ermittlung der Eignung gebrauchter Batterien für einen eventuellen Second-Life-Einsatz kann eine Messung der Restkapazität durch einen oder wenige Vollzyklen und die Messung des Innenwiderstand an einem Ladezustandspunkt erfolgen. Unter Umständen kann die Restkapazität auch durch Auslesen des Batteriemanagementsystems ermittelt werden, wenn dort ein zuverlässiger, ausreichend genauer State-of-Health-Wert (SOH) gespeichert ist. Aufgrund dieser Zustandsinformationen können die gebrauchten Batterien in möglichst homogene Gruppen eingeteilt werden, die sich durch eine möglichst enge Verteilungskurve ihrer Eigenschaften auszeichnen. Batterien aus einer Gruppe werden dann zu einem Speicher oder Batterierack verbaut und zusammengeschaltet. Dadurch wird zwar gewährleistet, dass die einzelnen Batterien eines Racks oder Speichers aktuell ähnliches Verhalten zeigen und somit alle gleichermaßen belastet werden. Letzterer Punkt verhindert dann, dass durch den Einsatz im Energiespeicher einzelne Batterien bezogen auf ihren aktuellen Zustand überlastet werden und so stärker altern als andere Zellen oder Module im gleichen Rack oder Speicher.

Nachteilig bei dem oben genannten konventionellen Ansatz ist jedoch, dass die genannten Größen Restkapazität und Innenwiderstand nur den aktuellen Zustand, aber nicht den zeitlichen Trend wiedergeben. Das bedeutet, dass die zu erwartende zeitliche Entwicklung des Gesundheitszustands der Batterie in den nächsten Betriebsphasen nicht bekannt ist. Es kann also beispielsweise sein, dass zwei Batterien jeweils eine Restkapazität von 80% haben. Dabei ist eine im bisherigen use case vorsichtig betrieben worden und befindet sich noch in einem Zustand, bei dem sich der Kapazitätsverlust langsam und mit nahezu linearem Verlauf fortsetzt. Dagegen kann die andere Batterie auf Grund eines harschen Betriebsmodus bereits einem schnellen Verlust der Kapazität bei zukünftigen Lade-Entladezyklen unterliegen, so dass bei weiterem Betrieb in einem stationären Energiespeicher ein steiler Kurvenverlauf der Alterungskurve zu erwarten ist. Man spricht dabei vom sogenannten Kniepunkt, der den Übergang vom langsamen, oft linearen Verlauf der Alterungskurve zu einem deutlich steileren und oft konvex gekrümmten (also sich beschleunigenden) Kurvenverlauf markiert. Die beiden Batterien würden sich beim weiteren Betrieb schnell in ihren Eigenschaften auseinander entwickeln, so dass sich nach kurzer Betriebszeit ein inhomogen zusammengesetztes Speichersystem entwickeln würde.

Aus Zhang Shuzhi et al, "A rapid online calculation method for state of health of lithium-ion battery based on coulomb counting method and differential voltage analysis", Jour. of Power Sources, Bd. 479, 31. August 2020 ist eine Berechnungsmethode für den SOH (state of health) von Lithium-Ionen-Batterien basierend auf Stromintegration bekannt.

Aus Zheng, Yuejiu et al, "Study on the correlation between state of charge and coulombic efficiency for commercial lithium ion batteries", Jour. Of Power Sources, Bd. 289, 18. Mai 2015, pp.: 81-90 sind Zusammenhänge zwischen dem State of Charge (SOC) und der Coulomb-Effizienz bekannt.

Aus der JP 2020/009677 A ist ein Verfahren zum Testen von Batterien bekannt, bei dem zuerst ein Entladevorgang und dann eine Folge von Lade- und Entladevorgängen durchgeführt wird.

Aufgabe der vorliegenden Erfindung ist es, ein Verfahren und eine Vorrichtung anzugeben, mit dem eine verbesserte Restwertbestimmung an gebrauchten Batterien ermöglicht ist.

Diese Aufgabe wird durch ein Verfahren mit den Merkmalen von Anspruch 1 und eine Vorrichtung mit den Merkmalen von Anspruch 14 gelöst.

Bei dem erfindungsgemäßen Verfahren zur Ermittlung des Restwerts einer Batterie wird die Batterie einer Teststation zugeführt und in der Teststation auf eine Testtemperatur gebracht. Die Testtemperatur wird dabei für die Dauer des Tests so stabilisiert, dass die auftretenden Abweichungen von der Testtemperatur geringer als 2 K sind.

Weiterhin wird eine Mehrzahl von Lastzyklen der Batterie mittels einer Hoch-Präzisions-Coulometrie-Vorrichtung vermessen, wobei das Ergebnis der Messung eine Mehrzahl von Stromwerten umfasst. Dabei wird für die Lastzyklen bevorzugt ein möglichst aussagekräftiger, gleichzeitig aber auch schonender Arbeitspunkt gewählt, insbesondere mit einem Ladezustand von weniger als 50%.

Die Messung wird bis zur Erfüllung eines Abbruchkriteriums durchgeführt und anhand des Ergebnisses der Messung wird ein erster und zweiter Wert für eine Entladekapazität der Batterie durch eine erste und eine zweite Rechenvorschrift ermittelt, wobei eine Kalibrierung der Strommessung unterschiedlich in die erste und zweite Rechenvorschrift eingeht, und ein Optimierungsverfahren durchgeführt, bei dem eine Kalibrierung der Strommessung ermittelt wird, mit der die größte Übereinstimmung der ermittelten ersten und zweiten Entlade-Kapazität erreicht ist.

Schließlich wird anhand der Ergebnisse der Messung wenigstens ein Restwertkriterium der Batterie bestimmt und anhand des Restwertkriteriums bestimmt, ob die Batterie für einen Einsatz in einem stationären Energiespeicher verwendet wird.

Die erfindungsgemäße Vorrichtung ist ausgestaltet zur Durchführung des erfindungsgemäßen Verfahrens und umfasst eine Temperierkammer, eine Hoch-Präzisions-Coulometrie-Vorrichtung und eine Recheneinheit mit einem Speicher zur Aufnahme von Ergebnissen einer Messreihe an der Batterie, wobei die Recheneinheit ausgestaltet ist, das Optimierungsverfahren und die Bestimmung vorzunehmen, ob die Batterie in einem stationären Batteriespeicher verwendet wird.

Unter der Restwertbestimmung wird dabei nicht notwendigerweise eine Bestimmung eines rein monetären Restwerts verstanden, sondern eine technische und wirtschaftliche Entscheidung, ob ein Einsatz in einem stationären Energiespeicher sinnvoll ist. Es handelt sich also zumindest in Teilen auch um eine Bestimmung der Restlebensdauer (Remaining Useful Life, RUL).

Mit der Erfindung wird vorteilhaft eine Möglichkeit geschaffen, eine sehr genaue Einschätzung des Restwerts einer Batterie zu erhalten. Mit dieser Einschätzung können stationäre Energiespeicher unter Verwendung gebrauchter Batterien mit deutlich verringertem Risiko für nachfolgenden Wartungsaufwand, Ausfall oder vorzeitiger Untauglichkeit der Batterie geschaffen werden. Es wird also eine deutlich verbesserte Möglichkeit der Nutzung von solchen Lithium-Ionen-Akkus bereitgestellt, deren Einsatz in Fahrzeugen nicht mehr sinnvoll oder erwünscht ist. Dies ist auch unter Umweltaspekten vorteilhaft, da damit dem später folgenden Recycling der Rohstoffe eine weitere Nutzung vorangestellt wird.

Besonders vorteilhaft ist dabei, dass nicht nur eine aktuelle Restkapazität, sondern auch eine Alterungsgeschwindigkeit ermittelt wird. Da also die zukünftige Geschwindigkeit des Kapazitätsverlustes bereitgestellt wird, ist eine deutlich verbesserte Zuordnung der Batterie zu einer Gruppe von Batterien mit gleichartigem Alterungsverhalten ermöglicht. Somit ist gewährleistet, dass auch während des Betriebs die Batterien eines stationären Energiespeichers längere Zeit ähnliche Eigenschaften behalten und sich nicht auseinander entwickeln. Man kann feststellen, ob man noch deutlich vor oder schon am Kniepunkt ist oder vielleicht sogar schon darüber hinaus gekommen und im steilen Kurvenverlauf der Alterungskurve ist.

Vorteilhaft ist weiterhin, dass bei der erfindungsgemäßen Messung bereits Teilzyklen zur Charakterisierung der aktuellen Degradationsrate genutzt werden können, so dass neben des Zeitgewinns ein weiterer Vorteil des vorgeschlagenen Verfahrens ist, dass keine zusätzliche Alterung durch Vollzyklen verursacht wird.

Vorteilhafte Ausgestaltungen der Erfindung gehen aus den von Anspruch 1 abhängigen Ansprüchen hervor. Dabei kann die Ausführungsform nach Anspruch 1 oder Anspruch 14 mit den Merkmalen eines der Unteransprüche oder vorzugsweise auch mit denen aus mehreren Unteransprüchen kombiniert werden. Demgemäß können noch zusätzlich folgende Merkmale vorgesehen werden:
Die Testtemperatur kann für die Dauer des Tests so stabilisiert werden, dass die auftretenden Abweichungen von der Testtemperatur geringer als 0,5 K, insbesondere sogar geringer als 0,05 K sind. Eine derart genau eingestellte Temperatur während der HPC-Messung sorgt für besonders aussagekräftige Messergebnisse. Für den Erfolg von stationären Energiespeichern mit gebrauchten Batterien ist es sehr wichtig, dass das Verhalten der eingesetzten gebrauchten Batterien möglichst lange und möglichst genau dem vorhergesagten Verhalten entspricht. Da dieses Verhalten aus einer momentanen Messung ermittelt wird, ist es wichtig, dass diese Messung möglichst genau ist.

Die Testtemperatur kann für die Dauer des Tests unter Verwendung des Kühlsystems der Batterie stabilisiert werden. Hierdurch wird der bauliche Aufwand, der für die Temperaturregelung der Batterie während der Messung erforderlich ist, reduziert.

Im Batteriemanagementsystem der Batterie gespeicherte Daten können als zusätzliche Restwertkriterien verwendet werden. Die Verwendung der im Batteriemanagementsystem gespeicherten Daten bietet den Vorteil, dass weitere Daten zur Verfügung stehen, um eine möglichst genaue Bestimmung des Restwerts vorzunehmen. Während diese weiteren Daten zwar nicht als Teil der Hoch-Präzisions-Coulometrie-Messung gewonnen werden und daher in der Genauigkeit hinter dieser zurückstehen werden, bieten sie Daten, die im tatsächlichen Betrieb der Batterie, also unter den Bedingungen ihres vormaligen Einsatzes gewonnen wurden. Diese Bedingungen bieten also möglicherweise einen Einblick in das Verhalten der Batterie an Arbeitspunkten, die in der HPC-Messung nicht verwendet werden. Die Daten aus dem Batteriemanagementsystem bieten auch die Möglichkeit einer Vorselektion. Dabei kann beispielsweise eine Batterie gar nicht mehr vermessen werden, wenn sie anhand der Daten des Batteriemanagementsystems absehbar nicht in Frage kommt für eine Second-Life-Anwendung. Alternativ kann auch das Abbruchkriterium für die Messung angepasst werden und somit wertvolle Messzeit gespart werden.

Als Restwertkriterium können ein Coulomb-Wirkungsgrad, ein energetischer Wirkungsgrad, ein effektiver Zell-Innenwiderstand und/oder ein Kapazitätsverlust pro Zyklus der Batterie bestimmt werden.

Die Restwertkriterien müssen also nicht alle der HPC-Messung entnommen werden, sondern können auch aus anderen Quellen stammen. Solche Quellen stehen gerade bei gebrauchten Batterien besonders gut zur Verfügung. Ein weiteres Restwertkriterium ist die Kapazität. Diese kann aus dem Batteriemanagementsystem entnommen werden oder in einer gesonderten Qualifizierungsmessung ermittelt werden.

Werden zwei oder mehr der genannten Größen verwendet, dann erfolgt die Entscheidung über den Restwert der Batterie vorteilhaft anhand einer Mehrzahl unabhängiger, in einer einzelnen Messung bestimmter KPI (Key Performance Indicators). Dadurch steigt die Robustheit des Auswahl-Prozesses, die Aussagekraft steigt und es eröffnen sich neue Möglichkeiten für die Integration von Daten-Rückflüssen aus dem Feldeinsatz der produzierten Batterien.

Aus der Kapazität lässt sich vorteilhaft eine Abschätzung des aktuell möglichen Energiedurchsatzes gewinnen. Aus dem elektrischen Innenwiderstand der Batterie lässt sich vorteilhaft eine Abschätzung der notwendigen Kühlleistung gewinnen.

Je mehr Restwertkriterien ermittelt werden, desto besser lässt sich auch eine Auslegung eines kostengünstigen stationären Batteriesystems vornehmen, bei dem die im System gruppierten Batterien ein möglichst identisches elektrisches, thermisches und Alterungsverhalten aufweisen sollten.

Die Restwertkriterien können zusammen mit einer Identifikationskennung für die Batterie in einer Datenbank abgelegt werden. Eine solche Speicherung ermöglicht eine spätere Auswertung der so gesammelten Daten, beispielsweise um Unterschiede bezüglich verschiedener Vorleben der verwendeten gebrauchten Batterien zu erkennen. Weiterhin erlaubt die Speicherung einen Vergleich mit Alterungsdaten, die im späteren Einsatz der Batterien als stationäre Energiespeicher gewonnen werden. So ist es besonders vorteilhaft, wenn reale Alterungsdaten von Batterien im Einsatz in einem Batteriespeicher empfangen werden und unter Verwendung der realen Alterungsdaten und der gespeicherten Restwertkriterien bestimmt wird, ob die aktuell betrachtete Batterie für einen Einsatz in einem stationären Energiespeicher verwendet wird.

Die Lastzyklen können eine Entladung von weniger als 40%, insbesondere weniger als 25% umfassen. Weiterhin können die Lastzyklen mit einem C-Koeffizient von zwischen 0,5 und 1,5, insbesondere zwischen 0,8 und 1,2 arbeiten. Hierdurch wird zusammen mit der Ladung ein vorteilhafter Arbeitspunkt für die Vermessung der Batterie geschaffen, bei dem der Ladezustand (SOC) zusammen mit der Entladung (DOD) nicht zu hoch ist, um die entstehenden Stromkosten zu senken und andererseits die Entladung ausreichend für eine aussagekräftige Messung ist. Ein solcher vorteilhafter Arbeitspunkt ist 30% SOC, 20% DOD und 1C.

Wenigstens für einen Teil der Lastzyklen können ein oder mehrere weitere Arbeitspunkte verwendet werden, die verschieden sind vom bereits genannten Arbeitspunkt. Dadurch wird die Vermessung aussagekräftiger mit Bezug auf verschiedene im realen Betrieb der Batterie auftretende Arbeitssituationen. Beispielsweise kann ein zweiter Arbeitspunkt mit 50% SOC, 10% DOD und 0,5C und insbesondere ein dritter Arbeitspunkt mit 75% SOC, 20% DOD und 0,2C vermessen werden.

Aus den Restwertkriterien kann eine Kategorie von stationärem Energiespeicher ermittelt werden, für den sich die Batterie am besten eignet. So kann beispielsweise anhand verschiedener Arbeitspunkte ermittelt werden, ob sich die Batterie am ehesten für den Einsatz in einem Energiespeicher für Regelleistung, Peak Shaving oder als Zwischenspeicher für erneuerbare Energien eignet. Diese unterschiedlichen Einsatzformen stellen verschiedene Anforderungen an die verwendeten Batterien, wodurch deren Alterung unterschiedlich verläuft.

Dadurch wird nicht nur ermöglicht, die gebrauchten Batterien in homogenere Gruppen bezüglich ihrer Alterungseigenschaften einzuteilen, sondern es kann vorteilhaft auch noch eine gezielte Empfehlung für deren neues Einsatzszenario gegeben werden.

Ein Lastzyklus umfasst dabei bevorzugt ein erstes Entladen, bei dem eine erste Ladungsmenge von einem ersten Ladungszustand zu einem zweiten Ladungszustand gemessen wird, ein sich anschließendes erstes Laden, bei dem eine zweite Ladungsmenge von dem zweiten Ladungszustand zu einem dritten Ladungszustand gemessen wird und ein zweites Entladen, bei dem eine dritte Ladungsmenge von dem dritten Ladungszustand zu einem vierten Ladungszustand gemessen wird, wobei das Laden und Entladen des Lastzyklus zwischen einer unteren Spannung und einer oberen Spannung des Batteriespeichers erfolgt.

Dabei kann eine erste Ladungsverschiebung mittels einer Differenz des vierten Ladungszustands und des zweiten Ladungszustands und eine zweite Ladungsverschiebung mittels einer Differenz des dritten Ladungszustands und des ersten Ladungszustands bestimmt werden. Ferner kann ein Kapazitätsverlust aus der Differenz der ersten Ladungsverschiebung und der zweiten Ladungsverschiebung bestimmt werden und ein mittlerer Kapazitätsverlust basierend auf wenigstens zwei Kapazitätsverlusten verschiedener Lastzyklen ermittelt werden.

Der so ermittelte Kapazitätsverlust kann als Abbruchkriterium verwendet werden. Insbesondere kann dabei die relative Änderung des Kapazitätsverlusts in zwei oder mehr aufeinander folgenden Lastzyklen betrachtet werden.

Ist diese ausreichend gering, so kann die Batterie als bereits eingeschwungen angesehen werden und die Vermessung abgebrochen werden.

Der so ermittelte Kapazitätsverlust kann auch als Restwertkriterium der Batterie verwendet werden. Somit steht neben den bereits erwähnten Restwertkriterien ein weiteres solches zur Verfügung, das die Aussagekraft der Messung verbessert.

Es ist möglich, das Abbruchkriterium als Funktion der sich nach dem bereits vorliegenden Messergebnis ergebenden Einordnung der Batterie zu wählen. So kann beispielsweise eine Messung abgebrochen werden, wenn sich für eine Batterie abzeichnet, dass sie als Ausschuss betrachtet werden muss, also für den Einsatz in einem stationären Energiespeicher nicht in Betracht kommt.

Die verwendeten Abbruchkriterien können miteinander kombiniert werden. So kann beispielsweise ein Abbruch der Messung erfolgen, wenn eine Mindest-Anzahl der bisher vermessenen Lastzyklen überschritten ist und die Abweichung der Kapazitätsverluste einen Schwellwert unterschreitet.

Für die Erfindung kann ein Computerprogrammprodukt vorliegen, das direkt in einen Speicher einer programmierbaren Recheneinheit einer erfindungsgemäßen Vorrichtung ladbar ist. Es umfasst Programmcode-Mittel, um das erfindungsgemäße Verfahren auszuführen, wenn das Computerprogrammprodukt in der Recheneinheit ausgeführt wird.

Weitere Merkmale, Eigenschaften und Vorteile der vorliegenden Erfindung ergeben sich aus der nachfolgenden Beschreibung unter Bezugnahme auf die beiliegenden Figuren. Darin zeigen schematisch:

Figur 1    eine Vorrichtung zur Restwertermittlung für eine gebrauchte Batterie,

Figur 2    ein Verfahrensschema zur Restwertermittlung für die Batterie mittels der Vorrichtung,

Figur 3    ein Spannungs-Zeit-Diagramm eines Lastzyklus,

Figur 4    ein Spannungs-Ladungs-Diagramm eines Lastzyklus,

Figur 5    ein Diagramm des Kapazitätsverlusts im Verlauf der Lastzyklen.

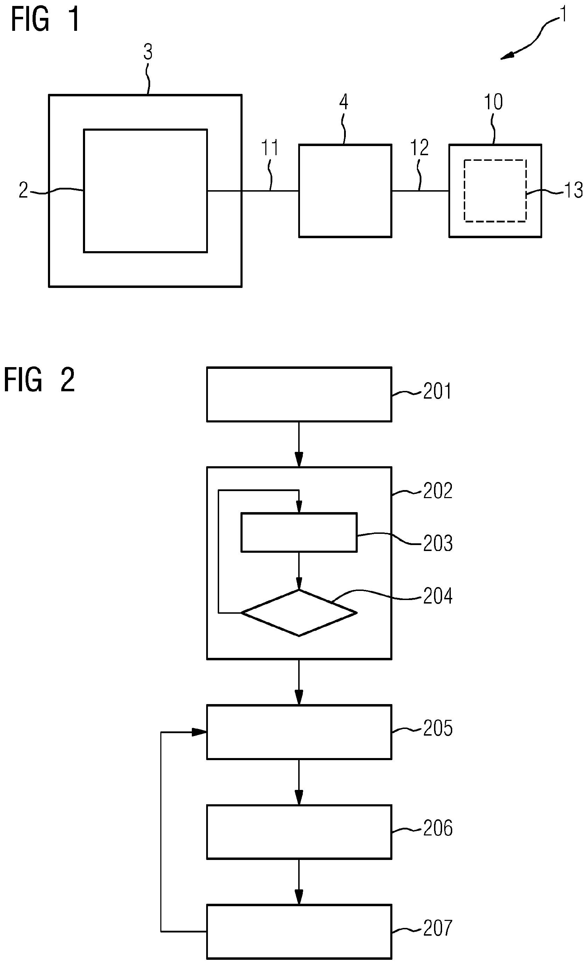

Figur 1 zeigt eine Vorrichtung 1 zur Restwertermittlung für eine gebrauchte Batterie 2. Die Vorrichtung 1 umfasst eine Hoch-Präzisions-Coulometrie-Vorrichtung 4 und eine Temperierkammer 3. Eine gebrauchte Batterie 2 wird in die Temperierkammer 3 eingebracht und mittels eines Stromkabels 11 mit der Hoch-Präzisions-Coulometrie-Vorrichtung 4 verbunden. Weiterhin wird ein in Figur 1 nicht dargestelltes Kühlsystem der Batterie 2 so mit der Temperierkammer 3 verbunden, dass das Kühlsystem für die Stabilisierung der Temperatur der Batterie 2 mitverwendet werden kann. Die Stabilisierung passiert dabei so, dass für den Zeitraum der Messungen eine sehr konstante Temperatur eingehalten wird. Die Temperatur kann beispielsweise 25 °C betragen und die Abweichungen im Zeitraum der Messungen betragen in diesem Ausführungsbeispiel weniger als 0,1 K.

Die Hochpräzisions-Coulometrie-Vorrichtung 4 ist ihrerseits mit einer Recheneinheit 10 über ein Datenkabel 12 verbunden. Die Hochpräzisions-Coulometrie-Vorrichtung 4 nimmt mit sehr großer Genauigkeit ein Ladungs-Zeit-Diagramm der Batterie 2 auf. Die Batterie 2 wird dabei mit einem periodischen Lastzyklus 100 betrieben.

Die Recheneinheit 10 umfasst ein Computerprogramm 13, das die Verarbeitung der von der Hochpräzisions-Coulometrie-Vorrichtung 4 übermittelten Daten durchführt. Das Computerprogramm speichert die Werte zumindest vorübergehend.

Figur 2 zeigt ein Verfahrensschema für ein Verfahren zur Restwertermittlung für die Batterie 2, das mit der in Figur 1 gezeigten Vorrichtung 1 durchgeführt wird. Die rechnerischen Schritte des Verfahrens werden dabei von dem Computerprogramm 13 auf der Recheneinheit 10 durchgeführt.

In einem ersten Schritt 201 wird eine gebrauchte Batterie 2 in die Temperierkammer 3 eingebracht und temperiert. Damit wird eine gleichbleibende Temperatur während der nachfolgend vermessenen Lastzyklen 100 erreicht. Der erste Schritt 201 kann in manchen Ausführungsformen bedingt durch die Art der Zuführung der Batterie 2 zur Temperierkammer 3 entfallen und in anderen Ausführungsformen kann dieser Schritt 201 einige Stunden andauern.

Auf den ersten Schritt 201 folgt ein zweiter Schritt 202, in dem eine Vermessung der Batterie 2 mittels der Hochpräzisions-Coulometrie-Vorrichtung 4 vorgenommen wird. Dabei werden die bereits erwähnten Lastzyklen 100 durchfahren und zumindest Strommessungen durchgeführt, die eine Bestimmung der Ladungsmengen erlaubt.

Der zweite Schritt 202 umfasst auch einen dritten Schritt 203, in dem mit den ermittelten Daten eine Stromkalibrierung durchgeführt wird. Weiterhin umfasst der zweite Schritt 202 auch einen vierten Schritt 204, in dem eine Entscheidung getroffen wird, ob ein Abbruchkriterium vorliegt. Ist das nicht der Fall, wird die Vermessung der Batterie 2 fortgesetzt mit einem weiteren Lastzyklus 100.

Der dritte und vierte Schritt 203, 204 können dabei nach jedem Lastzyklus oder immer nach einer festlegbaren Zahl von weiteren vermessenen Lastzyklen durchgeführt werden. Dabei sind der dritte und vierte Schritt 203, 204 im Prinzip unabhängig voneinander, können aber auch zu gemeinsamen Zeiten durchgeführt werden. Im vorliegenden Beispiel werden der dritte und vierte Schritt 203, 204 nach jeweils 10 Lastzyklen 100 ausgeführt.

Als Abbruchkriterium wird in diesem Ausführungsbeispiel eine Kombination verschiedener Faktoren verwendet. Ein erster Faktor ist eine Mindestanzahl von Lastzyklen 100, in diesem Fall 100. Erfahrungsgemäß ist ein Einschwingen des Verhaltens einer Batterie nicht vor dieser Anzahl von Lastzyklen 100 erreicht. Als weiterer Faktor wird eine Abweichung des Kapazitätsverlusts zwischen aufeinander folgenden Lastzyklen 100 verwendet. Diese wird in der Folge noch beschrieben. Unterschreitet diese Abweichung 5%, kann von einem eingeschwungenen Zustand der Batterie 2 ausgegangen werden.

Weiterhin wird in die Abbruchkriterien einbezogen, welches Ergebnis sich für die Batterie 2 ergeben würde, wenn die bisherigen Daten nach der Mindestanzahl an Lastzyklen 100 berücksichtigt werden. Ist das Ergebnis bereits so, dass die Batterie nicht mehr geeignet ist für einen Einsatz in einem stationären Energiespeicher, wird die weitere Vermessung abgebrochen. Weist die Batterie 2 dagegen eine hohe zu erwartende Qualität bezüglich der Alterung auf, wird die Vermessung fortgesetzt.

Ist das Abbruchkriterium erfüllt, wird die Vermessung der Batterie 2 beendet. Es erfolgt dann in einem fünften Schritt 205 eine Bestimmung von endgültigen Restwertkriterien. In diesem Beispiel wird in dem fünften Schritt 205 eine Coulomb-Effizienz und ein energetischer Wirkungsgrad bestimmt. Diese Restwertkriterien werden dann ausgewertet, beispielsweise indem sie einzeln mit festlegbaren Schwellwerten verglichen werden. Diese Auswertung ist wenigstens in Teilen eine Wirtschaftlichkeitsauswertung, bei der geklärt wird, ob der Einsatz der Batterie 2 in einem stationären Energiespeicher bei Berücksichtigung ihrer erwartbaren Alterungseigenschaften voraussichtlich gewinnbringend ist. In anderen Teilen ist sie auch eine Sicherheitsbetrachtung, bei der geklärt wird, ob der Einsatz der Batterie vertretbar ist, beispielsweise also keine Brandgefahr von ihm ausgeht. Es kann hier eine Wirtschaftlichkeitsbetrachtung durchgeführt werden, wie sie auch in bei Energiespeicherung aus neuen Batterien durchgeführt wird, wobei die gemessenen Daten an die Stelle von Herstellerdaten zur Batterie treten.

Ergibt diese Auswertung, dass sich ein Einsatz in einem stationären Energiespeicher, also ein Second-Life-Einsatz für die Batterie 2 nicht lohnt, dann wird diese beispielsweise einem Rohstoff-Recycling zugeführt. Die gewonnen Daten und Restwertkriterien können verworfen werden.

Ergibt die Auswertung der Restwertkriterien jedoch, dass die Batterie 2 für einen Einsatz in einem stationären Energiespeicher geeignet ist, dann werden in einem sechsten Schritt 206 die gewonnenen Restwertkriterien gespeichert. Die Speicherung der ermittelten Werte erfolgt in einer Datenbank zusammen mit einer Identifikationskennung, beispielsweise einer Seriennummer für die Batterie 2. Weiterhin werden dort auch Kennwerte gespeichert, die aus dem Batteriemanagementsystem der Batterie 2 entnommen werden.

Hierzu ist die Recheneinheit 10 auch mit dem Batteriemanagementsystem verbunden, um einen Datenaustausch vornehmen zu können. Vom Batteriemanagementsystem können typischerweise Daten wie die geschätzte Restkapazität und in einem Fehlerspeicher hinterlegte Informationen entnommen werden. Daten zur geschätzten Restkapazität können ergänzt werden durch eine eigene Kapazitätsmessung nach dem Datenblatt der Batterie 2 oder einem anderweitigen Testprotokoll.

Da die im fünften Schritt 205 bestimmten Restwertkriterien zusammen mit der Identifikationskennung gespeichert sind, kann in einem siebten Schritt 207 ein Abgleich der so ermittelten Vorhersagewerte mit tatsächlichen Alterungsdaten für die Batterien 2 erfolgen. Dazu werden solche tatsächlichen Alterungsdaten an den Batterien 2 im Laufe ihres Second-Life-Einsatzes im stationären Energiespeicher aufgenommen. Diese Daten werden mit den gespeicherten Restwertkriterien, die momentanen Messwerten entsprechen, und den aus dem Batteriemanagementsystem entnommenen Daten, die Daten aus dem Vorleben entsprechen, verglichen. Zeigen sich dabei systematische Abweichungen des erwarteten Restwerts, also der Betriebseigenschaften im stationären Energiespeicher, die mit einem oder mehreren der Restwertkriterien korrelieren, dann wird eine Korrektur der im fünften Schritt 205 vorgenommenen Auswertung vorgenommen, beispielsweise eine Veränderung der Schwellwerte. Diese veränderten Schwellwerte führen zu einer verbesserten Restwertbestimmung für künftig getestete gebrauchte Batterien 2.

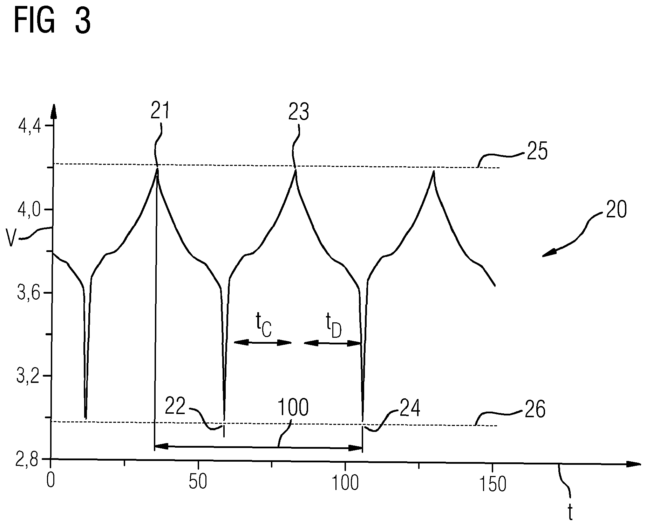

Die eigentliche Vermessung der Batterien 2 erfolgt mittels der Hochpräzisions-Coulometrie-Vorrichtung 4. Figur 3 zeigt ein Spannungs-Zeit-Diagramm, das die Hochpräzisions-Coulometrie-Vorrichtung 4 während eines periodischen Lastzyklus 100 der Batterie 2 aufgezeichnet hat. Ein Lastzyklus 100 umfasst ein Entladen von einem ersten Ladezustand 21 zu einem zweiten Ladezustand 22, wobei der erste Ladezustand 21 bei einer oberen Spannung 25 liegt und der zweite Ladezustand 22 bei einer unteren Spannung 26 liegt. Anschließend wird in dem Lastzyklus 100 der Batteriespeicher 2 von dem zweiten Ladezustand 22 zu einem dritten Ladezustand 23 geladen. Als nächster Schritt wird in dem Lastzyklus 100 der dritte Ladezustand 23 bis zu einem vierten Ladezustand 24 entladen. In jedem einzelnen Lade-/Entladeschritt wird eine obere Spannung 25 und eine untere Spannung 26 als Spannungsgrenzen eingehalten. Das Laden dauert den Ladezeitraum $t_C$. Das Entladen dauert den Entladezeitraum $t_D$.

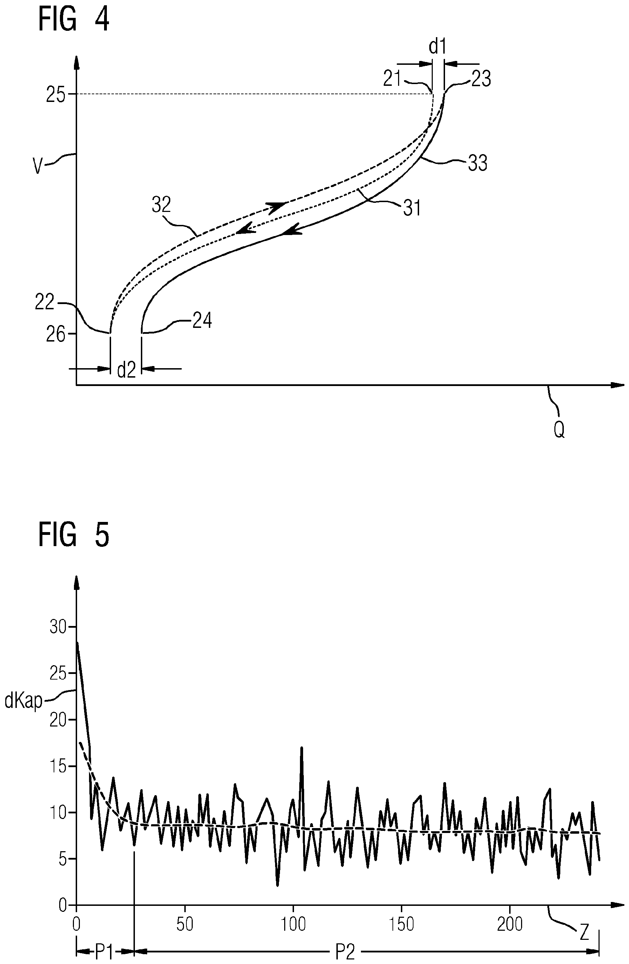

Basierend auf der in Figur 3 gezeigten Messung kann nun, wie in Figur 4 dargestellt, ermittelt werden, welche kumulative Ladungsmenge in den einzelnen Lade- und Entlade-Schritten geflossen ist. Figur 4 zeigt ein Diagramm, in welchem die Spannung des Batteriespeichers über der kumulativen Ladungsmenge Q aufgetragen ist. Der Lastzyklus 100 beginnt wiederum bei dem ersten Ladezustand 21. Der Batteriespeicher 2 wird bis zu dem zweiten Ladezustand 22 bei dem ersten Entladen 31 entladen. Dabei wird eine erste Ladungsmenge Q1 aus dem Batteriespeicher 2 entnommen. Die erste Ladungsmenge Q1 kann über Gleichung 1 berechnet werden, wobei I den Stromfluss und $t_D$ den Entladezeitraum bezeichnet:

$$Q1 = \int^{t_D} I(t)\,dt \qquad\qquad \text{Gleichung 1}$$

Innerhalb des Lastzyklus 100 wird der Batteriespeicher 2 anschließend von dem zweiten Ladezustand 22 zu dem dritten Ladezustand 23 mittels eines ersten Ladens 32 geladen. Es wird eine zweite Ladungsmenge Q2 in den Batteriespeicher 2 geladen. Q2 kann mittels der Gleichung 2 berechnet werden:

$$Q2 = \int^{t_C} I(t)\,dt \qquad\qquad \text{Gleichung 2}$$

Innerhalb des Lastzyklus 100 wird der Batteriespeicher 2 anschließend von dem dritten Ladezustand 23 zu dem vierten Ladezustand 24 mittels eines zweiten Entladens 33 entladen.

Die entnommene Ladungsmenge Q3 kann wiederum analog zu Gleichung 1 aus dem Zeitraum des Entladens dem dazugehörigen Stromfluss berechnet werden.

Nun ist es möglich, zwischen dem ersten Ladezustand 21 und dem dritten Ladezustand 23 eine erste Ladungsverschiebung d1 zu ermitteln. Weiterhin kann eine zweite Ladungsverschiebung d2 zwischen dem zweiten Ladezustand 22 und dem vierten Ladezustand 24 ermittelt werden. Aus der Differenz der ersten Ladungsverschiebung d1 und der zweiten Ladungsverschiebung d2 kann nun ein Kapazitätsverlust dKap für den Lastzyklus 100 mittels Gleichung 3 ermittelt werden.

$$dKap = d2 - d1 \qquad\qquad \text{Gleichung 3}$$

In Figur 5 ist nun der Kapazitätsverlust pro Lastzyklus für 250 Lastzyklen dargestellt. Dabei befinden sich auf der x-Achse die Lastzykluszahl Z, also die laufende Anzahl des jeweiligen Lastzyklus 100, auf der y-Achse befindet sich der Kapazitätsverlust dKap pro Lastzyklus 100. Figur 5 verdeutlicht, dass zunächst eine Einschwingphase P1 während der nacheinander folgenden Lastzyklen 100 auftritt. Die Länge der Einschwingphase P1 ist abhängig vom Arbeitspunkt und der Vorgeschichte der Batterie 2.

Die Bestimmung des mittleren Kapazitätsverlusts $dKap_{mittel}$ als Messwert des Verfahrens erfolgt durch einen gleitenden linearen Fit über die Werte des Kapazitätsverlusts dKap und das Bestimmen der kleinsten Steigungen in den so erzeugten Geradengleichungen. Ausgehend von einem Fit über alle Werte des Kapazitätsverlusts dKap, also Wert 1 bis Wert 250, wird der Datensatz laufend gekürzt und eine neue Gerade erzeugt (angefittet) (2 bis 250, 3 bis 250, usw.). Der Fit wird durchgeführt bis zu einer bestimmten minimalen Restlänge des Datensatzes, z. B. 10 % der Gesamtlänge. Im Anschluss werden die Geradengleichungen insbesondere nach den Werten ihrer Steigungen der Größe nach ansteigend sortiert. Die Messung kann dann als gültig angesehen werden, wenn wenigstens zwei der Steigungen betragsmäßig einen Wert kleiner als 10 % des Mittelwertes der letzten 10 % der Kapazitätsverluste dKap aufweisen. Beträgt beispielsweise der Mittelwert der letzten zwanzig Kapazitätsverluste, insbesondere bei einer Messung von wenigstens 200 Kapazitätsverlusten, 5 mAh/Lastzyklus, dann sollte sie Steigung der beiden besten angepassten Tangenten ("Fits") weniger als 0,5 mAh/Lastzyklus aufweisen.

Ansonsten ist die Messung, insbesondere mit einer größeren Anzahl an Stützpunkten, zu wiederholen, weil kein ausreichend stationärer Zustand des Systems erreicht wurde. Aus der Sortierung wird eine bestimmte Anzahl, beispielsweise abgerundet 3 % der Gesamtlänge des Datensatzes, bzw. eine minimale Anzahl von zwei Messwerten, ausgewählt und die entsprechenden Startindizes der gefitteten Geraden ermittelt. Für jeden der so ermittelten Abschnitte wird ein gemittelter Kapazitätsverlust als arithmetischer Mittelwert über die eingeschlossenen Kapazitätsverluste dKap angegeben. Der Wert des mittleren Kapazitätsverlusts $dKap_{Mittel}$ wird anschließend als Mittelwert über die gemittelten einzelnen Kapazitätsverluste bestimmt.

Ist noch kein ausreichend stationärer, also im Wesentlichen konstanter, Kapazitätsverlust erreicht, wird die Messung des Lastzyklus wiederholt. Aus der Sortierung wird dann wiederum eine bestimmte Anzahl, z. B. abgerundet 3 % der Gesamtlänge des Datensatzes, bzw. eine minimale Anzahl von zwei, ausgewählt und die entsprechenden Startindizes der gefitteten Geraden ermittelt. Für jeden der so ermittelten Abschnitte wird der mittlere Kapazitätsverlust $dKap_{Mittel}$ als arithmetischer Mittelwert über die eingeschlossenen Kapazitätsverluste angegeben. Der Wert des mittleren Kapazitätsverlusts $dKap_{Mittel}$ kann aber auch als Mittelwert über die arithmetisch gemittelten Kapazitätsverluste ermittelt werden.

Figur 5 verdeutlicht auch, dass sich an die Einschwingphase P1 eine Ermittlungsphase P2 anschließt. Diese Phasen können sich während der Auswertung der Kapazitätsverluste dKap verschieben.

Neben dem Kapazitätsverlust wird auch die Coulomb-Effizienz als Restwertkriterium verwendet. Diese berechnet sich zu

$$CE = {Q3}/{Q2} \qquad\qquad \texttt{Gleichung 4}$$

Für die im dritten Schritt durchgeführte Stromkalibrierung kann ausgenutzt werden, dass sich eine Entladekapazität Q0, die einem entladenen Zustand, also beispielsweise dem zweiten Ladezustand zugeordnet werden kann, auf zwei unterschiedliche Arten berechnet werden kann, wobei die Stromkalibrierung der Hoch-Präzisions-Coulometrie-Vorrichtung 4 unterschiedlich in beide Berechnungen eingeht. So ist Q0 gemäß einer ersten Vorschrift

$$Q_0 = \frac{d2}{1-CE} \qquad\qquad \texttt{Gleichung 5}$$

Weiterhin lässt sich Q0 aus einer anfänglichen Entladekapazität Q0A, die einem vorhergehenden Lastzyklus 100 zugeordnet ist, und den Kapazitätsverlusten zwischen dem vorhergehenden Lastzyklus 100 und dem aktuellen Lastzyklus berechnen:

$$Q_{0m} = Q_{0A} + \sum dKap \qquad\qquad \texttt{Gleichung 7}$$

Im Falle einer idealen, also fehlerfreien Strommessung sind die beiden Werte gleich, d.h.

$$Q_0 = Q_{0m} \qquad\qquad \texttt{Gleichung 8}$$

Die beiden Werte fallen in der Realität jedoch durch die in der Strommessung vorliegende Stromkalibrierung, die nicht vollkommen exakt ist, auseinander. Je größer die Differenz der Werte, desto fehlerhafter ist die Stromkalibrierung.

Die Gleichung 8 wird in der Form $f = Q_0 - Q_{0m}$ als Basis für eine Optimierung verwendet, bei der der Funktionswert f zu minimieren ist. Die für die Optimierung zu variierenden Größen bilden die Stromkalibrierung. Die Stromkalibrierung ist eine Abbildung von einem gemessenen Stromwert auf einen korrigierten Messwert. Wird durch die Optimierung eine weitgehende Übereinstimmung zwischen den Werten erreicht, dann entsprechen die korrigierten Messwerte sehr genau dem realen Stromfluss. Die Optimierung wird in der Recheneinheit 10 vom Computerprogramm 13 vorgenommen.

Bezugszeichenliste

| | |
|---|---|
| 1 | Vorrichtung |
| 2 | Batterie |
| 3 | Temperierkammer |
| 4 | Hoch-Präzisions-Coulometrie-Vorrichtung |
| 10 | Recheneinheit |
| 11 | Stromkabel |
| 12 | Datenkabel |
| 13 | Computerprogrammprodukt |
| 21 | erster Ladezustand |
| 22 | zweiter Ladezustand |
| 23 | dritter Ladezustand |
| 24 | vierter Ladezustand |
| 25 | obere Spannung |
| 26 | untere Spannung |
| 100 | Lastzyklus |

$t_C$        Ladezeitraum
$t_D$        Entladezeitraum
201...207     erster Schritt ... siebter Schritt

**Patentansprüche**

1.  Verfahren zur Ermittlung des Restwerts einer gebrauchten Batterie (2), bei dem

    - die Batterie (2) einer Teststation (1) zugeführt wird,
    - die Batterie (2) in der Teststation (1) auf eine Testtemperatur gebracht wird und die Testtemperatur für die Dauer des Tests so stabilisiert wird, dass die auftretenden Abweichungen von der Testtemperatur geringer als 2 K sind,
    - eine Mehrzahl von Lastzyklen (100) der Batterie (2) mittels einer Hoch-Präzisions-Coulometrie-Vorrichtung (4) vermessen werden, wobei das Ergebnis der Messung eine Mehrzahl von Stromwerten umfasst,
    - die Messung bis zur Erfüllung eines Abbruchkriteriums durchgeführt wird,
    - anhand des Ergebnisses der Messung ein erster und zweiter Wert für eine Entladekapazität der Batterie (2) durch eine erste und eine zweite Rechenvorschrift ermittelt wird, wobei eine Kalibrierung der Strommessung unterschiedlich in die erste und zweite Rechenvorschrift eingeht, und ein Optimierungsverfahren durchgeführt wird, bei dem eine Kalibrierung der Strommessung ermittelt wird, mit der die größte Übereinstimmung der ermittelten ersten und zweiten Entlade-Kapazität erreicht ist,
    - anhand der Ergebnisse der Messung wenigstens ein Restwertkriterium der Batterie (2) bestimmt wird,
    - anhand des Restwertkriteriums bestimmt wird, ob die gebrauchte Batterie (2) für einen Einsatz in einem stationären Energiespeicher verwendet wird.

2.  Verfahren nach Anspruch 1, bei dem die Testtemperatur für die Dauer des Tests so stabilisiert wird, dass die auftretenden Abweichungen von der Testtemperatur geringer als 0,5 K, insbesondere geringer als 0,05 K sind.

3.  Verfahren nach Anspruch 1 oder 2, bei dem die Testtemperatur für die Dauer des Tests unter Verwendung eines Kühlsystems der Batterie (2) stabilisiert wird.

4.  Verfahren nach einem der vorangehenden Ansprüche, bei dem die Kapazität der Batterie (2) und/oder im Batteriemanagementsystem der Batterie (2) gespeicherte Daten als zusätzliche Restwertkriterien verwendet werden.

5.  Verfahren nach einem der vorangehenden Ansprüche, bei dem als Restwertkriterium ein Coulomb-Wirkungsgrad, ein energetischer Wirkungsgrad, ein effektiver Zell-Innenwiderstand und/oder ein Kapazitätsverlust pro Zyklus der Batterie (2) bestimmt wird.

6.  Verfahren nach einem der vorangehenden Ansprüche, bei dem die Restwertkriterien mit einer Identifikationskennung für die Batterie (2) in einer Datenbank abgelegt werden.

7.  Verfahren nach Anspruch 6, bei dem reale Alterungsdaten von mit diesem Verfahren getesteten Batterien (2) im Einsatz in einem stationären Batteriespeicher empfangen werden und unter Verwendung der realen Alterungsdaten und der gespeicherten Restwertkriterien bestimmt wird, ob die Batterie für einen Einsatz in einem stationären Energiespeicher verwendet wird.

8.  Verfahren nach einem der vorangehenden Ansprüche, bei dem die Lastzyklen (100) eine Entladung von weniger als 40%, insbesondere weniger als 25% umfassen und mit einem C-Koeffizient von zwischen 0,5 und 1,5, insbesondere zwischen 0,8 und 1,2 arbeiten.

9.  Verfahren nach einem der vorangehenden Ansprüche, bei dem aus den Restwertkriterien eine Kategorie von stationärem Energiespeicher ermittelt wird, für den sich die Batterie (2) am besten eignet.

10. Verfahren nach einem der vorangehenden Ansprüche, bei dem ein Lastzyklus (100) ein erstes Entladen umfasst, bei dem eine erste Ladungsmenge von einem ersten Ladungszustand (21) zu einem zweiten Ladungszustand (22) gemessen wird, ein sich anschließendes erstes Laden, bei dem eine zweite Ladungsmenge von dem zweiten Ladungszustand (22) zu einem dritten Ladungszustand (23) gemessen wird und ein zweites Entladen, bei dem eine dritte Ladungsmenge von dem dritten Ladungszustand (23) zu einem vierten Ladungszustand (24) gemessen wird, wobei das Laden und Entladen des Lastzyklus (100) zwischen einer unteren Spannung und einer oberen Spannung der Batterie (2) erfolgt.

11. Verfahren gemäß Anspruch 10, bei dem

- eine erste Ladungsverschiebung mittels einer Differenz des vierten Ladungszustands (24) und des zweiten Ladungszustands (22) und eine zweite Ladungsverschiebung mittels einer Differenz des dritten Ladungszustands (23) und des ersten Ladungszustands (21) bestimmt wird,
- ein Kapazitätsverlust aus der Differenz der ersten Ladungsverschiebung und der zweiten Ladungsverschiebung bestimmt wird,
- ein mittlerer Kapazitätsverlust basierend auf wenigstens zwei Kapazitätsverlusten verschiedener Lastzyklen (100) ermittelt wird.

12. Verfahren gemäß Anspruch 11, bei dem als Abbruchkriterium die relative Änderung des Kapazitätsverlusts in zwei oder mehr aufeinander folgenden Lastzyklen (100) verwendet wird.

13. Verfahren nach einem der vorangehenden Ansprüche, bei dem das Abbruchkriterium als Funktion der sich nach dem vorliegenden Messergebnis ergebenden Klassifizierung gewählt wird.

14. Vorrichtung (1) zum Durchführen des Verfahrens nach einem der vorangehenden Ansprüche umfassend

- eine Temperierkammer (3),
- eine Hoch-Präzisions-Coulometrie-Vorrichtung (4),
- eine Recheneinheit (10) mit einem Speicher zur Aufnahme von Ergebnissen einer Messreihe an der Batterie (2), wobei die Recheneinheit (10) ausgestaltet ist, das Optimierungsverfahren durchzuführen.

15. Computerprogrammprodukt (13), das direkt in einen Speicher einer programmierbaren Recheneinheit (10) einer Vorrichtung nach Anspruch 14 ladbar ist, mit Programmcode-Mitteln, um ein Verfahren nach einem der Ansprüche 1 bis 13 auszuführen, wenn das Computerprogrammprodukt (13) in der Recheneinheit (10) ausgeführt wird.

**Claims**

1. Method for ascertaining the residual value of a used battery (2), in which

- the battery (2) is fed to a test station (1),
- the battery (2) in the test station (1) is brought to a test temperature and the test temperature is stabilised for the duration of the test such that the deviations from the test temperature that arise are less than 2 K,
- a plurality of load cycles (100) of the battery (2) are measured by means of a high-precision coulometry apparatus (4), wherein the result of the measurement comprises a plurality of current values,
- the measurement is carried out until the fulfilment of a termination criterion,
- on the basis of the result of the measurement, a first and a second value for a discharging capacity of the battery (2) is ascertained by way of a first and a second calculation rule, wherein a calibration of the current measurement is included differently in the first and the second calculation rule and an optimisation process is carried out in which a calibration of the current measurement is ascertained with which the largest matching of the ascertained first and second discharging capacity is achieved,
- on the basis of the results of the measurement, at least one residual value criterion of the battery (2) is determined,
- on the basis of the residual value criterion, it is determined whether the used battery (2) is to be employed for use in a static energy storage device.

2. Method according to claim 1, in which the test temperature is stabilised for the duration of the test such that the deviations from the test temperature that arise are less than 0.5 K, in particular less than 0.05 K.

3. Method according to claim 1 or 2, in which the test temperature is stabilised for the duration of the test by using a cooling system of the battery (2).

4. Method according to one of the preceding claims, in which the capacity of the battery (2) and/or data stored in the battery management system of the battery (2) is used as additional residual value criteria.

5. Method according to one of the preceding claims, in which as a residual value criterion, a coulomb efficiency, an energy efficiency, an effective cell internal resistance and/or a capacity loss per cycle of the battery (2) is determined.

6. Method according to one of the preceding claims, in which the residual value criteria are stored in a database with an identifier for the battery (2).

7. Method according to claim 6, in which real aging data of batteries (2) tested with this method is captured in use in a static battery storage device and while using the real aging data and the stored residual value criteria, it is determined whether the battery will be used for operation in a static energy storage device.

8. Method according to one of the preceding claims, in which the load cycles (100) comprise a discharging of less than 40%, in particular less than 25% and function with a C-coefficient of between 0.5 and 1.5, in particular between 0.8 and 1.2.

9. Method according to one of the preceding claims, in which from the residual value criteria, a category of static energy storage devices is ascertained for which the battery (2) is best suited.

10. Method according to one of the preceding claims, in which a load cycle (100) comprises a first discharging in which a first charge quantity is measured from a first charging state (21) to a second charging state (22), a subsequent first charging in which a second charge quantity is measured from the second charging state (22) to a third charging state (23) and a second discharging in which a third charge quantity is measured from the third charging state (23) to a fourth charging state (24), wherein the charging and discharging of the load cycle (100) takes place between a lower voltage and an upper voltage of the battery (2).

11. Method according to claim 10, in which

   - a first charge displacement is determined by means of a difference between the fourth charging state (24) and the second charging state (22) and a second charge displacement is determined by means of a difference between the third charging state (23) and the first charging state (21),
   - a capacity loss is ascertained from the difference between the first charge displacement and the second charge displacement,
   - a mean capacity loss is ascertained on the basis of at least two capacity losses of different load cycles (100).

12. Method according to claim 11, in which as the termination criterion, the relative change of the capacity loss in two or more successive load cycles (100) is used.

13. Method according to one of the preceding claims, in which the termination criterion is selected as a function of the classification arising according to the existing measurement result.

14. Apparatus (1) for carrying out the method according to one of the preceding claims, comprising

   - a temperature-controlled chamber (3),
   - a high-precision coulometry apparatus (4),
   - a computing unit (10) with a storage device for receiving results of a measurement series on the battery (2), wherein the computing unit (10) is configured to carry out the optimisation process.

15. Computer program product (13) which can be directly loaded into a memory store of a programmable computing unit (10) of an apparatus according to claim 14, having program code means in order to carry out a method according to one of claims 1 to 13 when the computer program product (13) is executed in the computing unit (10).

**Revendications**

1. Procédé de détermination de la valeur résiduelle d'une batterie (2) ayant servi dans lequel

   - on envoie la batterie (2) à un poste (1) d'essai,

- on porte la batterie (2) à une température d'essai dans le poste (1) d'essai et on stabilise la température d'essai pendant la durée de l'essai, de manière à ce que les écarts qui se produisent à la température d'essai soient plus petits que 2 K,
- on mesure une pluralité de cycles (100) de charge de la batterie (2), au moyen d'un système (4) de coulométrie de haute précision, le résultat de la mesure comprenant une pluralité de valeurs de courant,
- on effectue la mesure jusqu'à ce qu'un critère d'interruption soit satisfait,
- à l'aide du résultat de la mesure on détermine, par une première et une deuxième prescriptions de calcul, une première et une deuxième valeurs d'une capacité de décharge de la batterie (2), dans lequel un étalonnage de la mesure du courant entre d'une manière différente dans la première et la deuxième prescriptions de calcul, et on effectue un procédé d'optimisation, dans lequel on détermine un étalonnage de la mesure du courant, par lequel on obtient la coïncidence la plus grande entre les première et deuxième capacités de décharge, qui ont été déterminées,
- à l'aide des résultats de la mesure, on détermine au moins un critère de valeur résiduelle de la batterie (2),
- à l'aide du critère de valeur résiduelle, on détermine, si on utilise la batterie (2) ayant servi pour une utilisation dans un accumulateur d'énergie fixe.

2. Procédé suivant la revendication 1, dans lequel on stabilise la température d'essai pendant la durée de l'essai, de manière à ce que les écarts qui se produisent à la température d'essai soient plus petits que 0,5 K, en particulier plus petits que 0,05 K.

3. Procédé suivant la revendication 1 ou 2, dans lequel on stabilise la température d'essai pendant la durée de l'essai en utilisant un système de refroidissement de la batterie (2).

4. Procédé suivant l'une des revendications précédentes, **caractérisé en ce que** l'on utilise comme critère de valeur résiduelle supplémentaire, la capacité de la batterie (2) et/ou des données mises en mémoire dans le système de gestion de la batterie (2).

5. Procédé suivant l'une des revendications précédentes, dans lequel on détermine comme critère de valeur résiduelle, un rendement coulombien, un rendement énergétique, une résistance interne efficace de cellule et/ou une perte de capacité par cycle de la batterie (2).

6. Procédé suivant l'une des revendications précédentes, dans lequel on met les critères de valeur résiduelle avec une caractéristique d'identification de la batterie (2) dans une base de données.

7. Procédé suivant la revendication 6, dans lequel on reçoit des données de vieillissement réelles de batteries (2) mises à l'essai par ce procédé en utilisation dans un accumulateur de batterie fixe et, en utilisant les données de vieillissement réelles et les critères de valeur résiduelle mis en mémoire, on détermine si on utilise la batterie pour une utilisation dans un accumulateur d'énergie fixe.

8. Procédé suivant l'une des revendications précédentes, dans lequel les cycles (100) de charge comprennent une décharge de moins de 40%, en particulier de moins de 25% et travaillent avec un coefficient C compris entre 0,5 et 1,5, en particulier entre 0,8 et 1,2.

9. Procédé suivant l'une des revendications précédentes, dans lequel on détermine, à partir des critères de valeur résiduelle, une catégorie d'accumulateur d'énergie fixe, pour laquelle la batterie (2) convient au mieux.

10. Procédé suivant l'une des revendications précédentes, dans lequel un cycle (100) de charge comprend une première décharge, dans laquelle on mesure une première quantité de charge d'un premier état (21) de charge à un deuxième état (22) de charge, une première charge venant ensuite, dans laquelle on mesure une deuxième quantité de charge du deuxième état (22) de charge à un troisième état (23) de charge et une deuxième décharge, dans laquelle on mesure une troisième quantité de charge du troisième état (23) de charge à un quatrième état (24) de charge, la charge et la décharge du cycle (100) de charge s'effectuent entre une tension basse et une tension haute de la batterie (2).

11. Procédé suivant la revendication 10, dans lequel

- on détermine un premier décalage de charge, au moyen d'une différence entre le quatrième état (24) de charge et le deuxième état (22) de charge et un deuxième décalage de charge, au moyen d'une différence entre le troisième état (23) de charge et le premier état (21) de charge,
- on détermine une perte de capacité à partir de la différence entre le premier décalage de charge et le deuxième décalage de charge,
- on détermine une perte de capacité moyenne sur la base d'au moins deux pertes de capacité de cycles (100) de charge différents.

12. Procédé suivant la revendication 11, dans lequel on utilise comme critère d'interruption la variation relative de la perte de capacité dans deux ou plusieurs cycles (100) de charge successifs.

13. Procédé suivant l'une des revendications précédentes, dans lequel on choisit le critère d'interruption en fonction du classement ressortant du résultat présent de la mesure.

14. Installation (1) pour effectuer le procédé suivant l'une des revendications précédentes, comprenant

- une chambre (3) de mise en température,
- un système (4) de coulométrie de haute précision,
- une unité (10) informatique comprenant une mémoire d'enregistrement de résultats d'une série de mesures sur la batterie (2), dans laquelle l'unité (10) informatique est conformée pour effectuer le procédé d'optimisation.

15. Produit (13) de programme d'ordinateur, qui peut être chargé directement dans la mémoire d'une unité (10) informatique programmable d'une installation suivant la revendication 14, comprenant des moyens de code de programme pour exécuter un procédé suivant l'une des revendications 1 à 13, lorsque le produit (13) de programme d'ordinateur est exécuté dans l'unité (10) informatique.

FIG 1

FIG 2

FIG 3

## FIG 4

## FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2020009677 A

**In der Beschreibung aufgeführte Nicht-Patentliteratur**

- **ZHANG SHUZHI et al.** A rapid online calculation method for state of health of lithium-ion battery based on coulomb counting method and differential voltage analysis. *Jour. of Power Sources,* 31. August 2020, vol. 479

- **ZHENG, YUEJIU et al.** Study on the correlation between state of charge and coulombic efficiency for commercial lithium ion batteries. *Jour. Of Power Sources,* 18. Mai 2015, vol. 289, 81-90